# EUROPEAN PATENT APPLICATION

(11) **EP 4 527 975 A1**
(43) Date of publication of application: **26.03.2025**
(21) Application number: 23849934.7
(22) Date of filing: 24.07.2023
(51) Int. Cl.: C23C 16/455

(54) **HEAD FOR INJECTING REACTIVE GAS FOR FILM FORMATION AND METHOD FOR MANUFACTURING SAME**

(30) Priority: 03.08.2022 JP 2022124151
(71) Applicant: NHK Spring Co., Ltd., Yokohama-shi, Kanagawa 236-0004 (JP)
(72) Inventor: ARAKI, Yoshihito, Yokohama-shi, Kanagawa 236-0004 (JP); KANEDA, Noriyoshi, Yokohama-shi, Kanagawa 236-0004 (JP)
(74) Representative: Kehl, Ascherl, Liebhoff & Ettmayr Patentanwälte Partnerschaft mbB
(86) International application number: PCT/JP2023/026927
(87) International publication number: WO 2024/029379

(57) **Abstract**

Disclosed is a method for manufacturing a head including: diffusion-bonding a first plate and a second plate to each other; and forming, after the diffusion bonding, a nickel-containing film on surfaces of the first plate and the second plate with electroless plating. The first plate and the second plate are configured to have a channel through which the reactive gas passes from a side of the first plate to a side of the second plate in a state where the first plate and the second plate are bonded.

## Description

### TECHNICAL FIELD

An embodiment of the present invention relates to a head for ejecting reactive gas for film formation in an apparatus for forming or processing thin films and a manufacturing method thereof. Alternatively, an embodiment of the present invention relates to a stage for placing a substrate in an apparatus for forming or processing thin films and a manufacturing method thereof.

### BACKGROUND ART

Semiconductor devices are installed in almost all electronic devices and play an important role in the function of the electronic devices. Semiconductor devices are devices utilizing the semiconductor properties of silicon and the like and are structured by appropriately stacking patterned thin films of semiconductors, insulators, and conductors over a substrate. These thin films are formed by an evaporation method, a sputtering method, a chemical vapor deposition (CVD) method, or a chemical reaction of a substrate and are processed (patterned) by photolithography processes. In the formation and patterning of thin films, highly reactive gases such as halogen-based gases are used as gases for film formation. For example, patent literature 1 discloses a configuration of a head (also called a shower head) for ejecting highly reactive gases, in which a corrosion-resistant film such as a ceramic spraying film is attached by a sealing member to the portion of the head in contact with the highly reactive gas.

### CITATION LIST

### PATENT LITERATURE

Patent Literature 1:Japanese Laid-Open Patent Publication No. 2020-88317

### SUMMARY OF INVENTION

### TECHNICAL PROBLEM

An object of an embodiment of the present invention is to provide a film-forming component having a novel structure and capable of uniformly ejecting a gas for film formation in a film-forming apparatus and a manufacturing method thereof. For example, an object of an embodiment of the present invention is to provide a head capable of uniformly ejecting a gas for film formation in a film-forming apparatus, a stage for mounting a substrate which is an object for film formation, and a manufacturing method thereof.

### SOLUTION TO PROBLEM

An embodiment of the present invention is a method for manufacturing a head for ejecting a reactive gas for film formation. The method includes: diffusion-bonding a first plate and a second plate to each other; and forming, after the diffusion bonding, a nickel-containing film on surfaces of the first plate and the second plate with electroless plating. The first plate and the second plate are configured to have a channel through which the reactive gas passes from a side of the first plate to a side of the second plate in a state where the first plate and the second plate are bonded.

An embodiment of the present invention is a method for manufacturing a head for ejecting a reactive gas for film formation. The method includes: forming a nickel-containing film on surfaces of a first plate and a second plate with electroless plating; and diffusion-bonding the first plate and the second plate to each other after the formation of the nickel-containing film. The first plate and the second plate are configured to have a channel through which the reactive gas passes from a side of the first plate to a side of the second plate in a state where the first plate and the second plate are bonded.

An embodiment of the present invention is a head for ejecting a reactive gas for film formation. The head includes a first plate, a second plate diffusion-bonded to the first plate, and a nickel-containing film covering surfaces of the first plate and the second plate. The first plate and the second plate are configured to have a channel through which the reactive gas passes from a side of the first plate to a side of the second plate.

An embodiment of the present invention is a head for ejecting a reactive gas for film formation. The head includes a first plate and a second plate each coated with a nickel-containing film. The first plate and the second plate are bonded to each other through a first bonding layer in contact with the first plate and the second plate. The first bonding layer consists of the nickel-containing films of the first plate and the second plate. The first plate and the second plate are configured to have a channel through which the reactive gas passes from a side of the first plate to a side of the second plate.

### BRIEF DESCRIPTION OF DRAWINGS

FIG. 1 is a schematic cross-sectional view of a film-forming apparatus equipped with a head or a stage according to an embodiment of the present invention.
FIG. 2 is a schematic bottom view of a head according to an embodiment of the present invention.
FIG. 3 is a schematic top view of a head according to an embodiment of the present invention.
FIG. 4A is a schematic cross-sectional view of a head according to an embodiment of the present invention.
FIG. 4B is a schematic cross-sectional view of a head according to an embodiment of the present invention.
FIG. 5 is a schematic cross-sectional view of a head according to an embodiment of the present invention.
FIG. 6 is a schematic cross-sectional view showing a manufacturing method of a head according to an embodiment of the present invention.
FIG. 7A is a schematic cross-sectional view of a head according to an embodiment of the present invention.
FIG. 7B is a schematic cross-sectional view of a head according to an embodiment of the present invention.
FIG. 8 is a schematic cross-sectional view of a head according to an embodiment of the present invention.
FIG. 9A is a schematic cross-sectional view of a part of a head according to an embodiment of the present invention.
FIG. 9B is a schematic cross-sectional view of a part of a head according to an embodiment of the present invention.
FIG. 10 is a schematic cross-sectional view showing a manufacturing method of a head according to an embodiment of the present invention.
FIG. 11 is a schematic perspective view of a stage according to an embodiment of the present invention.
FIG. 12 is a schematic cross-sectional view of a stage according to an embodiment of the present invention.
FIG. 13A is a schematic cross-sectional view showing a manufacturing method of a stage according to an embodiment of the present invention.
FIG. 13B is a schematic cross-sectional view showing a manufacturing method of a stage according to an embodiment of the present invention.
FIG. 14 is a schematic cross-sectional view of a stage according to an embodiment of the present invention.

### DESCRIPTION OF EMBODIMENTS

Hereinafter, each embodiment of the present invention is explained with reference to the drawings. The invention can be implemented in a variety of different modes within its concept and should not be interpreted only within the disclosure of the embodiments exemplified below.

The drawings may be illustrated so that the width, thickness, shape, and the like are illustrated more schematically compared with those of the actual modes in order to provide a clearer explanation. However, they are only an example, and do not limit the interpretation of the invention. In the specification and the drawings, the same reference number is provided to an element that is the same as that which appears in preceding drawings, and a detailed explanation may be omitted as appropriate.

In the specification and drawings, the reference number is used when plural structures which are the same as or similar to each other are collectively represented, while a hyphen and a natural number are further used when these structures are independently represented.

In the specification and the claims, an expression "a structure is exposed from another structure" means a mode in which a part of the structure is not covered by the other structure and includes a mode where the part uncovered by the other structure is further covered by another structure. In addition, a mode expressed by this expression includes a mode where a structure is not in contact with other structures.

### <First Embodiment>

In this embodiment, a head 130 for ejecting reactive gases (hereinafter, simply referred to as reactive gases) according to an embodiment of the present invention is described. The head 130 is installed in film-forming apparatuses such as a CVD apparatus and an atomic layer deposition (ALD) apparatus and film-processing apparatuses such as an ashing apparatus and a dry-etching apparatus (hereinafter, film-forming apparatuses and film-processing apparatuses may be collectively referred to as film-forming apparatuses, and film formation and film processing may also be collectively referred to as film formation) and a component for ejecting reactive gases. A variety of gases may be used as the reactive gases, depending on the films to be fabricated. The reactive gas may be liquid at room temperature. For example, silane-based gases such as monosilane, dichlorosilane, and trichlorosilane, halogen-containing gases without a metal element such as fluorine, hydrogen fluoride, chlorine, and nitrogen trifluoride, halogen-containing gases including a metal element such as tungsten hexafluoride, germanium tetrachloride, molybdenum fluoride, and tungsten chloride, alkylmetals such as trialkylaluminum and trialkylgallium, fluorine-based etching gases such as sulfur hexafluoride, carbon tetrafluoride, and trifluoromethane, and the like are represented. For example, the use of silane-based gases allows the formation of thin films of silicon, silicon oxide, silicon nitride, and the like, while the use of tungsten fluoride, trimethylaluminum, or the like leads to the formation of thin metal films such as tungsten and aluminum. These reactive gases are generally highly reactive and corrosive, and the head 130 is provided with a configuration to prevent corrosion by reactive gases as described below.

### 1. Structure of Head

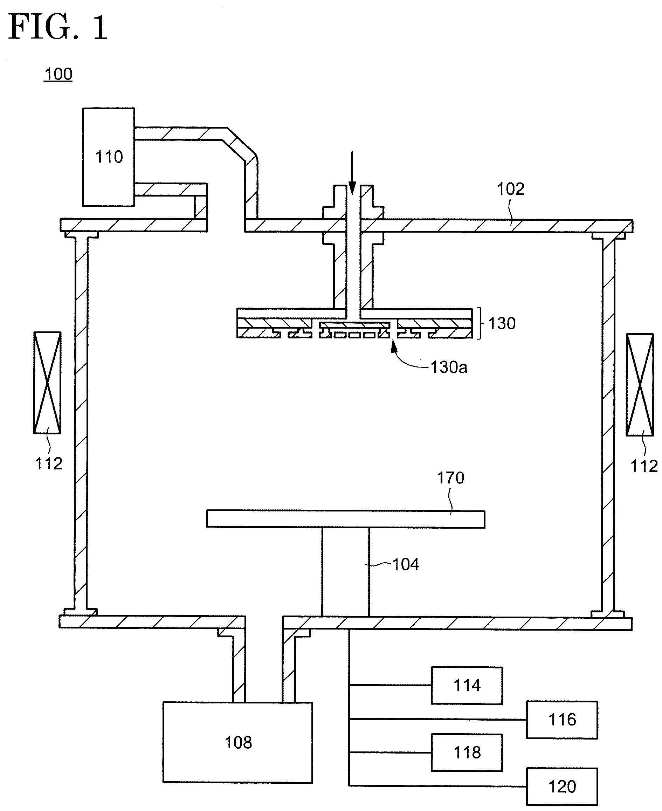

Hereinafter, a CVD apparatus is used as an example of film-forming apparatuses, and the structure of the head 130 used in the CVD apparatus is explained. FIG. 1 is a schematic cross-sectional view of the CVD apparatus 100. The CVD apparatus 100 has a chamber 102 to provide a space where reactive gases are chemically reacted. An exhaust device 108 is connected to the chamber 102 by which the pressure in the chamber 102 can be reduced. The head 130 is provided in the chamber 102, and a reactive gas is supplied to the head 130 from a source of the reactive gas, which is not illustrated (see the straight arrow in the drawing). The head 130 is provided with a plurality of openings 130a, and the reactive gas is supplied into the chamber 102 through the openings 130a.

A microwave source 110 may be connected to the chamber 102. Microwaves generated by the microwave source 110 are introduced into the chamber 102 to plasmatize the reactive gas. As a result, chemical reactions of the reactive gas are promoted by a variety of active species included in the plasma, and the products obtained by the chemical reactions are deposited over a substrate to form a thin film. A stage 160 according to an embodiment of the present invention is provided at a lower portion of the chamber 102, by which deposition of thin films can be performed in a state where the substrate is placed over the stage 160. The stage 160 is described in the Third Embodiment. A magnet 112 may be further provided on a side of the chamber 102. The magnet 112 may be a permanent magnet or an electromagnet with an electromagnetic coil. The magnet 112 creates a magnetic field component parallel to the stage 160 and a surface of the substrate by which the electrons in the plasma resonate under the Lorentz force in conjunction with the microwave electric field and are bound to the stage 160 and the surface of the substrate. As a result, a high-density plasma can be generated on the substrate surface.

The stage 160 is provided over a shaft 104. The stage 160 may further be connected to a power supply 114 for supplying high-frequency power to the stage 160, a heater power supply 116 for controlling a heater built into the stage 160, a power supply 118 for an electrostatic chuck disposed over the stage 160, a temperature controller 120 for controlling a temperature of a cooling medium circulated in the stage 160, and the like. The CVD apparatus 100 may further be provided with a rotation-controlling device (not illustrated) for rotating the stage 160 as an optional component.

In the above example, the head 130 is provided over the stage 160, and the reactive gas is supplied downward toward the stage 160. However, the stage 160 may be provided over the head 130, and the reactive gas may be supplied from the head 130 to the stage 160 side while the substrate is placed under the stage 160.

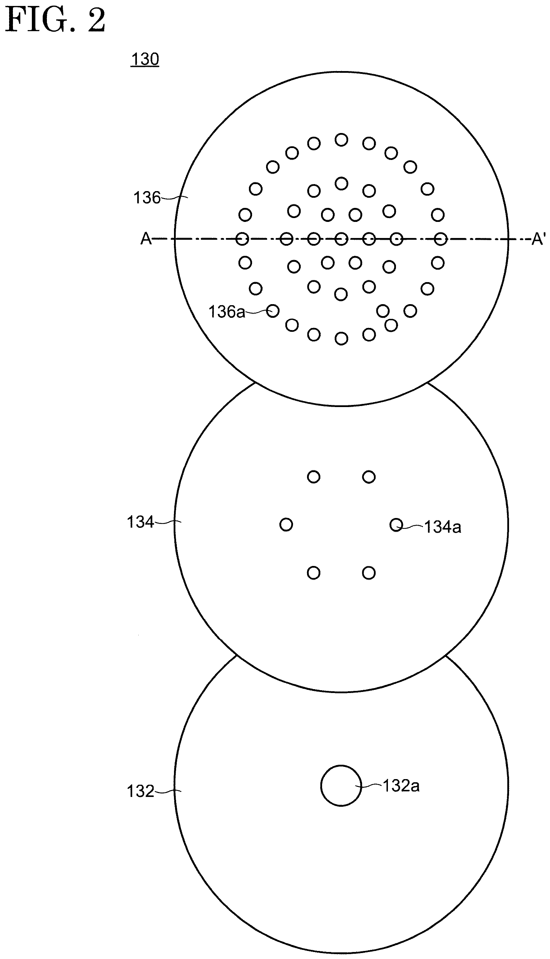

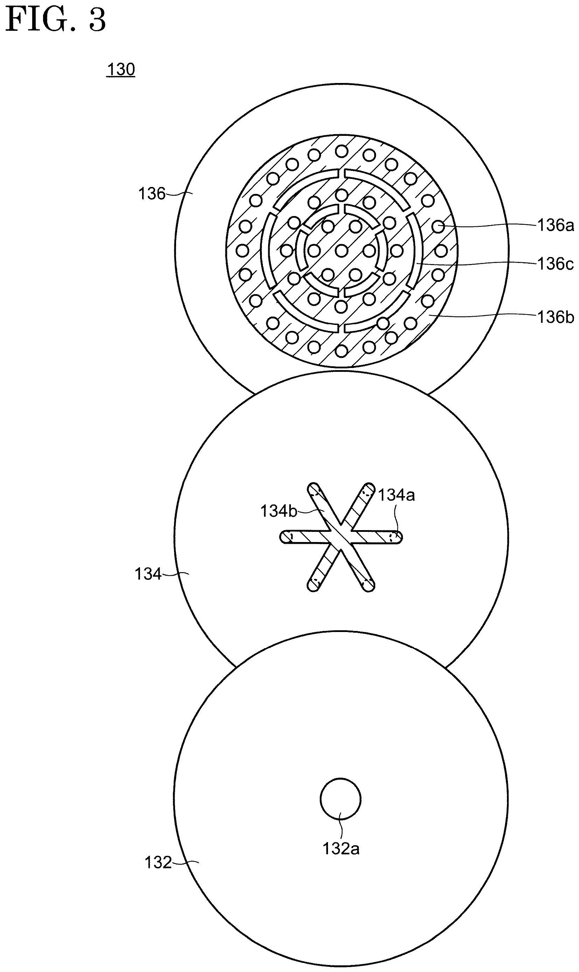

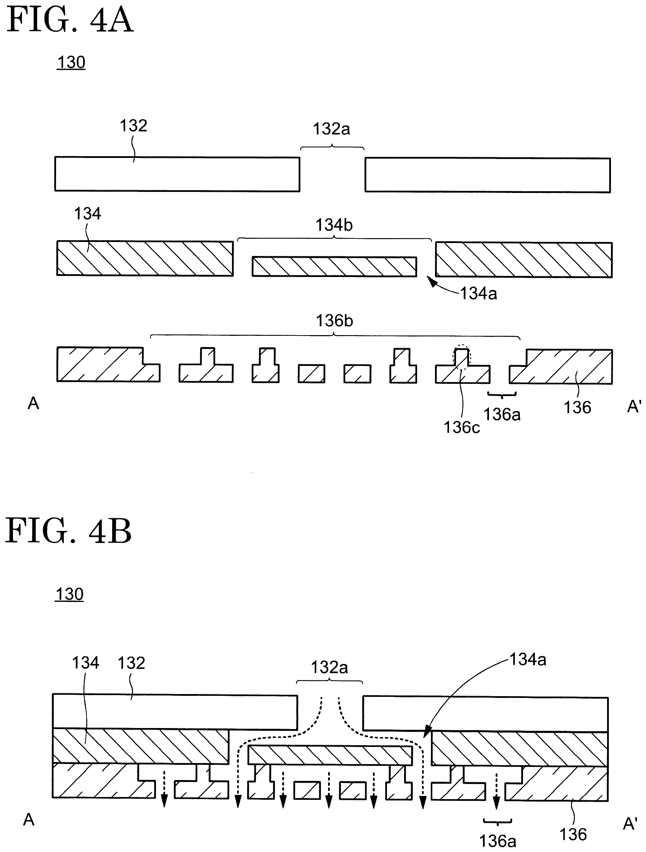

Schematic bottom and top views of an example of the head 130 are respectively shown in FIG. 2 and FIG. 3, and schematic cross-sectional views along the straight line passing through the center of the head 130 (see the chain line A-A' in FIG. 2) are shown in FIG. 4A and FIG. 4B. As can be understood from these drawings, the head 130 may have a first plate 132, a second plate 134, and a third plate 136. Note that a state where the first plate 132, the second plate 134, and the third plate 136 are separated from one another is shown in FIG. 2 to FIG. 4A for visibility. Although the planar shape of the head 130 (the shape observed from the normal direction of each plate. The same is applied hereinafter.) is a circle in the illustrated example, there is no restriction on the planar shape of the head 130, and a shape according to the substrate to be used may be adopted. For example, the planar shape of the head 130 may be square, rectangular, or other polygonal shape.

The first plate 132, the second plate 134, and the third plate 136 include a metal such as aluminum, iron, nickel, cobalt, and chromium as their constituent material (base material). Specifically, the base materials include a metal such as aluminum, an alloy containing aluminum and magnesium, an alloy containing iron as a major component, or alloy containing nickel as a major component, or the like. As an alloy containing iron as a major component, Invar containing iron and nickel, stainless steel containing iron and chromium, and the like are represented. Invar may contain manganese and carbon. Stainless steel may further contain nickel, molybdenum, carbon, and the like, and austenitic stainless steel, austenitic-ferritic stainless steel, ferritic stainless steel, and martensitic stainless steel may be used, for example. As an alloy containing nickel as a major component, Inconel containing nickel, chromium, and iron is represented. Inconel may further contain molybdenum, titanium, aluminum, carbon, and the like. The first plate 132, the second plate 134, and the third plate 136 preferably have the same composition as one another.

In the head 130, the first plate 132 and the second plate 134 are bonded, and the second plate 134 and the third plate 136 are bonded so that the second plate 134 is sandwiched between the first plate 132 and the third plate 136 as shown in FIG. 4B. Moreover, the head 130 has a channel to allow the reactive gas to pass from the first plate 132 side to the third plate 136 side in a state where the first plate 132, the second plate 134, and the third plate 136 are bonded.

The configuration of the channel may be set as appropriate. For example, in the example shown in FIG. 2 to FIG. 4B, a through hole 132a is provided in the center of the first plate 132, and the reactive gas is supplied to the head 130 through the through hole 132a. The second plate 134 is provided with a recessed portion 134b overlapping the through hole 132a in a normal direction thereof and facing the first plate 132, and a plurality of through holes 134a is provided in the recessed portion 134b. Since the recessed portion 134b is located on the first plate 132 side, the reactive gas is introduced into the recessed portion 134b through the through hole 132a and then supplied to the third plate 136 side through the through holes 134a. Similarly, the third plate 136 is provided with a recessed portion 136b overlapping the plurality of through holes 134a in a normal direction thereof and facing the second plate 134, and a plurality of through holes 136a is provided in the recessed portion 136b. The through holes 136a correspond to the openings 130a of the head 130 described above (FIG. 1). The recessed portion 136b may be provided with one or a plurality of partitions 136c for controlling the flow of the reactive gas. Since the recessed portion 136b is located on the second plate 134 side, the reactive gas supplied from the second plate 134 side is supplied into the recessed portion 136b and then ejected through the through holes 136a (see dotted arrows in FIG. 4B). In order to uniformly supply the reactive gas, the through holes 136a are formed relatively small. For example, the diameter of the through holes 136a is set in the range equal to or larger than 0.3 mm and equal to or smaller than 5 mm. The diameters of the through holes 132a and 134a are larger than those of through holes 136a.

Although not illustrated, one or a plurality of bolt holes may be provided on a top surface of the first plate 132 to fix the head 130 in the chamber 102.

As described below, the first plate 132 and the second plate 134 are bonded to each other by diffusion bonding. Similarly, the second plate 134 and the third plate 136 are also bonded to each other by diffusion bonding. Thus, the first plate 132 and the second plate 134 are in direct contact with each other, and the second plate 134 and the third plate 136 are also in direct contact with each other. In addition, at the interface between the first plate 132 and the second plate 134 and the interface between the second plate 134 and the third plate 136, there is no brazing material frequently used in metal-to-metal bonding, and no components derived from brazing materials (*e.g.*, silicon, germanium, phosphorus, copper, and the like) is present, or their concentrations are lower than their bulk concentrations in the first plate 132, the second plate 134, and the third plate 136. Furthermore, there is no brazing material or residue formed by the melting and resolidification of the brazing material on the surface facing the channel of the reactive gas. Specifically, the brazing material or the residue thereof does not exist on the side wall of the through hole 132a, the bottom surface of the first plate 132 facing the recessed portion 134b, the top surface of the recessed portion 134b, the bottom surface of the second plate 134 facing the recessed portion 136b, the side wall of the through holes 134a, the top surface of the recessed portion 136b, the top and side surfaces of the partition 136c, the side wall of the through holes 136a, and the like.

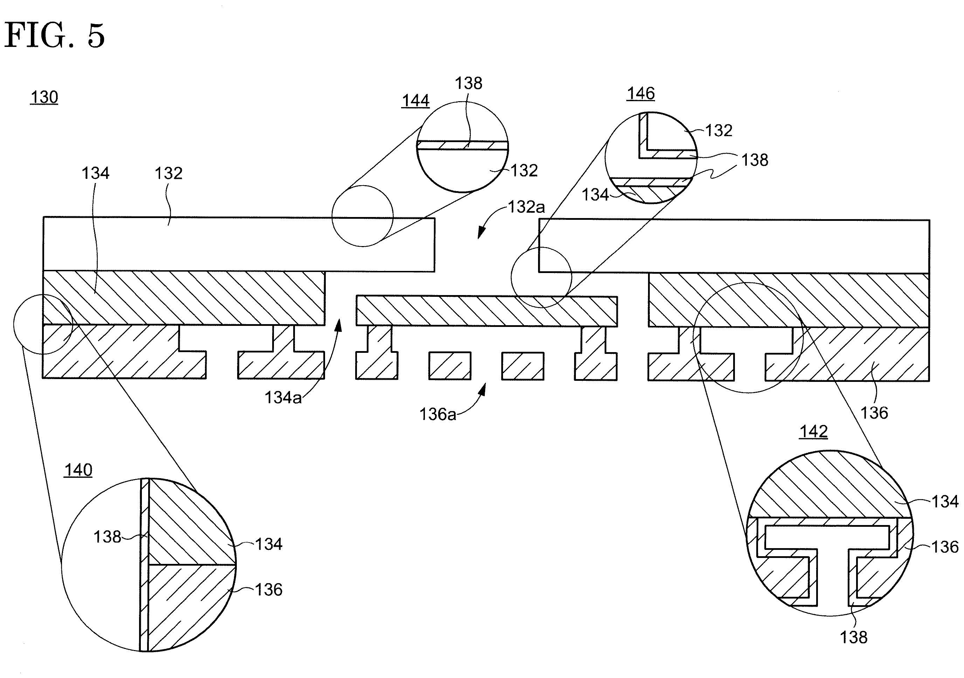

As described below, in the manufacturing process of the head 130, after diffusion-bonding the first plate 132, the second plate 134, and the third plate 136, a plating film containing nickel (nickel-containing film) is further provided by electroless plating. Therefore, the head 130 has a plating film 138 on the outer surfaces of the first plate 132, the second plate 134, and the third plate 136 as shown in the regions 140, 142, 144, 146, and the like represented in the enlarged view of FIG. 4B (FIG. 5). For example, as can be understood from the enlarged schematic view of the region 140, the plating film 138 is continuous over the side surfaces of adjacent plates (*i.e.*, the first plate 132 and the second plate 134, and the second plate 134 and the third plate 136). Moreover, the plating film 138 is also present on the bottom surface of the third plate 136 and the top surface of the first plate 132 as can be understood from the enlarged schematic view of the regions 142 and 144. Furthermore, the plating film 138 is also provided on the inner surface facing the channel of the reactive gas. That is, as can be understood from the enlarged schematic views of the regions 142 and 146, the plating film 138 exists on the sidewalls of the through holes 132a, 134a, and 136a, the top surface of the recessed portion 134b, the bottom surface of first plate 132 facing the recessed portion 134b, the top surface of recessed portion 136b, the bottom surface of the second plate 134 facing the recessed portion 136b, and the side surface and the top surface of the partition 136c.

The plating film 138 contains nickel as its major component and may contain phosphorus as a secondary component. The concentration of phosphorus is appropriately set in a range equal to or more than 1 wt% and equal to or less than 3 wt%, equal to or more than 2 wt% and equal to or less than 4 wt%, equal to or more than 5 wt% and equal to or less than 9 wt%, or equal to or more than 10 wt% and equal to or less than 15 wt%, for example. The thickness of the plating film 138 is also not restricted and may be appropriately set in a range equal to or more than 10 µm and equal to or less than 50 µm, equal to or more than 20 µm and equal to or less than 40 µm, or equal to or more than 25 µm and equal to or less than 35 µm, for example.

The formation of the plating film 138 by electroless plating allows not only the outer surfaces of the first plate 132, the second plate 134, and the third plate 136 but also the inner surface facing the channel to be covered by the corrosion-resistant plating film 138. That is, the head 130 can be configured so that the first plate 132, the second plate 134, and the third plate 136 are not exposed from the plating film 138 and are entirely covered by the plating film 138. Therefore, corrosion of the head 130 by reactive gases during film formation can be effectively prevented. Hence, it is possible to provide a highly corrosion-resistant head which can be used not only in the formation and processing of metal films, but also in the formation and processing of ceramic-containing films, which require high temperatures. In addition, unlike the films containing inorganic oxides such as ceramics, the expansion coefficient of the plating film 138 is relatively close to that of the base material included in the first plate 132, the second plate 134, and the third plate 136, which prevents peeling of the plating film 138 even when depositing films at high temperatures.

### 2. Manufacturing Method of Head

The first plate 132, the second plate 134, and the third plate 136 are fabricated by cutting a corresponding metal or alloy plate as appropriate. As described above, the structure of the channel in the head 130 may be arbitrarily determined.

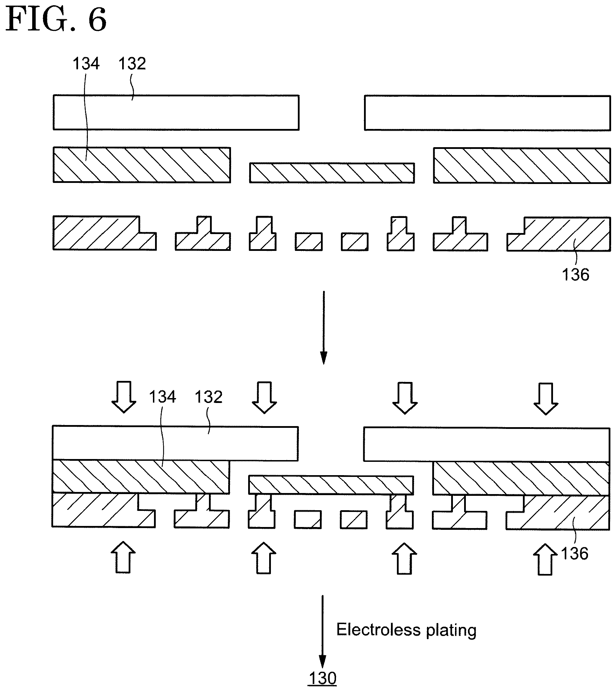

The first plate 132, the second plate 134, and the third plate 136 are bonded by diffusion bonding (FIG. 6). The first plate 132, the second plate 134, and the third plate 136 may be simultaneously bonded while placing the second plate 134 between the first plate 132 and the third plate 136, or two plates may be first bonded, which is followed by bonding the remaining plate. The diffusion bonding is performed by heating the plates at a temperature lower than the melting point of the base metal contained in the plates while applying pressure (see the white arrows in FIG. 6) between the plates under a reduced pressure. The pressure applied between the plates in the diffusion bonding may be selected from a range equal to or higher than 0.2 MPa and equal to or lower than 5 MPa, for example. The temperature for diffusion bonding may be selected from a range equal to or higher than 450 °C and lower than the melting point of the base metal.

After the bonding is completed, electroless plating is performed to produce the head 130 shown in FIG. 5 and the like. For example, the first plate 132, the second plate 134, and the third plate 136 after bonding may be immersed in an electrolyte solution containing a nickel salt such as nickel sulfate or nickel chloride and a reducing agent such as sodium hypophosphite. The electrolyte may contain a catalyst such as copper, gold, silver, platinum, palladium, rhodium, and ruthenium. The immersion time is appropriately adjusted according to the thickness of the plating film 138 to be formed and the temperature of the electrolyte solution. After the electroless plating is completed, the head 130 is cleaned with a cleaning solution such as water.

In the manufacturing method of the head 130 according to an embodiment of the present invention, diffusion bonding is used in bonding the first plate 132, the second plate 134, and the third plate 136, and brazing is not used in the bonding. Therefore, the brazing material used in brazing and its residues are not present on the outer surfaces or in the channel. As described above, in order to uniformly eject the reactive gas, the channel of the reactive gas formed in the head 130 is relatively narrow, and in particular, the diameter of the through hole 136a formed in the third plate 136 is approximately from several hundred µm to several mm (*e.g*., equal to or more than 0.3 mm and equal to or less than 5 mm). Therefore, if a brazing material or its residues remain in the channel including the through holes 136a, a part of the channel of the reactive gas is blocked, making it difficult to uniformly eject the reactive gas. As a result, the composition, the thickness, the density, and other characteristics of the film to be formed on the substrate become non-uniform. However, since the first plate 132, the second plate 134, and the third plate 136 are bonded using diffusion bonding in the manufacturing method of the head 130 according to an embodiment of the present invention, the influences caused by the presence of the brazing material or its residue are completely eliminated. As a result, it is possible to construct the channel in the head 130 as designed without affecting the channel of the reactive gas.

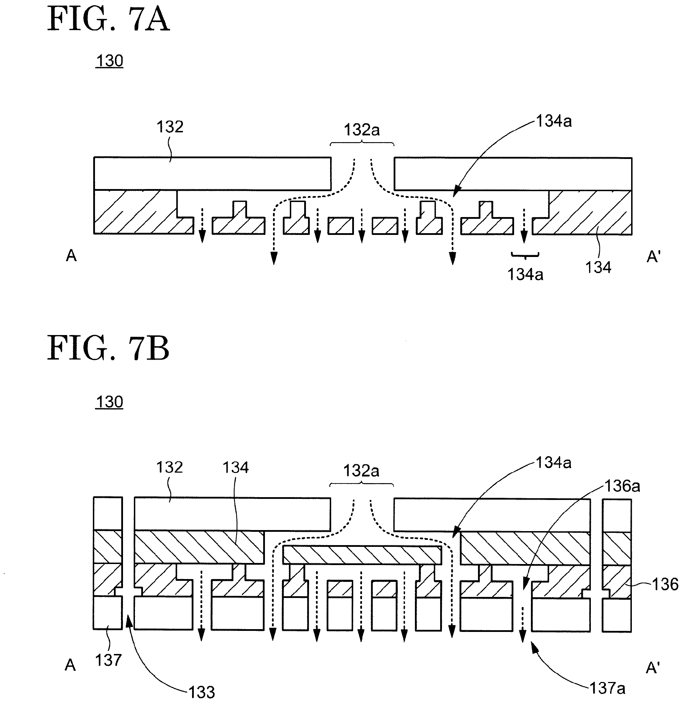

Although the head 130 has three plates diffusion-bonded to one another in the example above, the configuration of the head 130 is not limited thereto. For example, as shown in FIG. 7A, the head 130 may be configured with two plates (the first plate 132 and the second plate 134). Since the through holes 134a in the second plate 134 correspond to the openings 130a in the head 130 in this case, the diameter thereof is preferably adjusted to be equal to or larger than 0.3 mm and equal to or smaller than 5 mm. The first plate 132 and the second plate 134 are configured to have a channel through which the reactive gas passes from the first plate 132 side to the second plate 134 side.

Alternatively, as shown in FIG. 7B, the head 130 may be configured with four plates (the first plate 132 to the fourth plate 137). Since through holes 137a of the fourth plate 137 correspond to the openings 130a of the head 130, the diameter thereof is preferably adjusted to be equal to or larger than 0.3 mm and equal to or smaller than 5 mm. The first plate 132 to the fourth plate 137 are configured to have a channel through which the reactive gas passes from the first plate 132 side to the fourth plate 137 side. Similar to the case having three plates, the order of diffusion bonding is arbitrarily determined. Although not illustrated, the head 130 may be configured with five or more plates.

Furthermore, a plurality of channels may be provided in the head 130 regardless of the number of plates. For example, as shown in FIG. 7B, in addition to a continuous channel passing through the second plate 134 and the third plate 136 from the through hole 132a in the first plate 132 to the through holes 137a in the fourth plate 137, one or a plurality of channels 133 independent from this channel may be provided in the head 130. This configuration allows for the simultaneous supply of reactive gases with different flow rates or a plurality of reactive gases with different molecular structures.

### <Second Embodiment>

In this embodiment, a head 131 having different structure from that of the head 130 and a manufacturing method thereof are explained. An explanation for the structures the same as or similar to those described in the First Embodiment may be omitted.

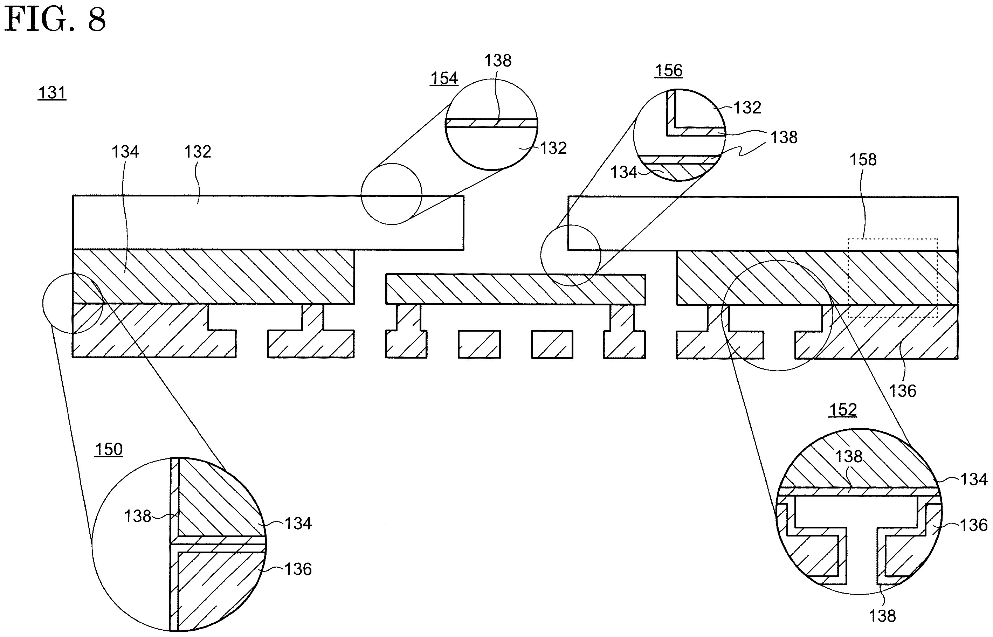

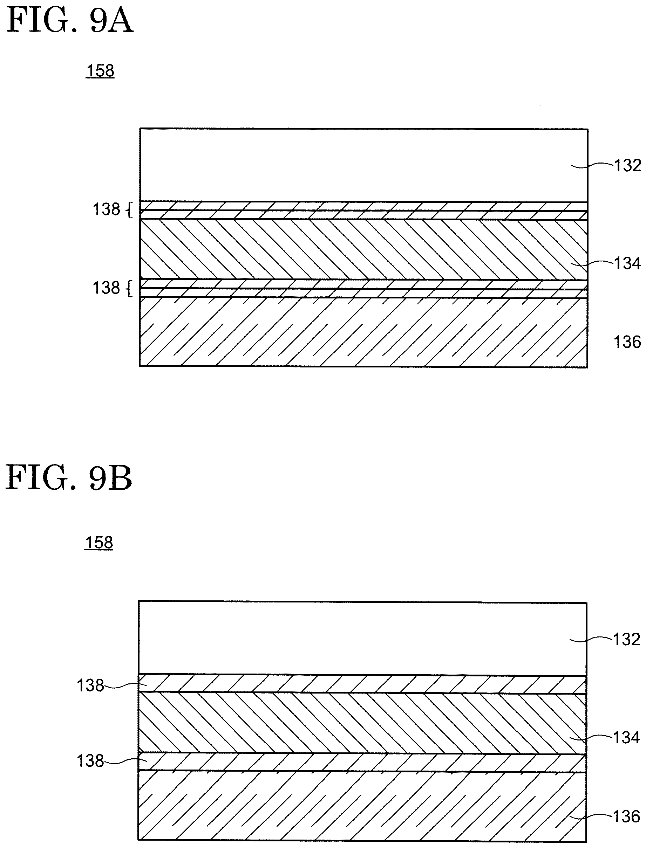

A schematic cross-sectional view of the head 131 is shown in FIG. 8. As can be understood from FIG. 8, a difference of the head 131 from the head 130 is that the head 131 has the plating film 138 not only on the surfaces of the first plate 132 to the third plate 136 but also between the first plate 132 and the second plate 134 and between the second plate 134 and the third plate 136. More specifically, as shown in the enlarged schematic views of the regions 150, 152, 154, and 156 in FIG. 8 and the enlarged schematic view of the region 158 (FIG. 9A), not only is the plating film 138 provided on the side surface and the top surface of the first plate 132, the side surface of the second plate 134, the top surface and the bottom surface of the third plate 136, and the inner surface facing the channel, but also the first plate 132 and the second plate 134 are bonded through the plating film 138, and the second plate 134 and the third plate 136 are bonded through the plating film 138. In other words, the first plate 132 and the second plate 134 are bonded via a bonding layer in direct contact with the first plate 132 and the second plate 134, and this bonding layer consists of the plating films 138 formed on the first plate 132 and the second plate 134. Similarly, the second plate 134 and the third plate 136 are bonded via a bonding layer in direct contact with the second plate 134 and the third plate 136, and this bonding layer consists of the plating films 138 formed on the second plate 134 and the third plate 136.

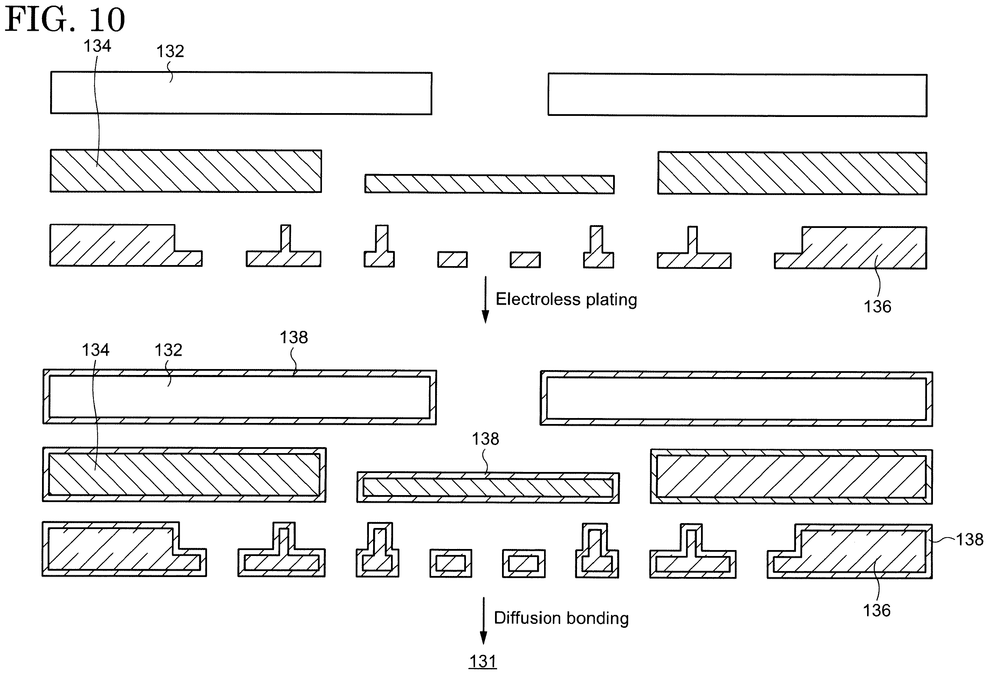

As can be understood from the schematic cross-sectional view shown in FIG. 10, unlike the head 130, the head 131 is manufactured by applying electroless plating to each of the first plate 132, the second plate 134, and the third plate 136 to form the plating film 138 on the surfaces thereof, followed by diffusion-bonding the first plate 132, the second plate 134, and the third plate 136. Therefore, the base materials included in the first plate 132, the second plate 134, and the third plate 136 are preferred to have a higher melting point than the plating film 138. Specifically, it is preferable that the base material be Invar, Inconel, or stainless steel. Furthermore, there may be two layers of the plating film 138 between adjacent plates as shown in FIG. 9A, or the two layers of the plating film 138 may be integrated by diffusion bonding to form one layer of the plating film 138 (FIG. 9B).

Similar to the head 130, not only the inner surface facing the channel of the reactive gas but also the top surface, the side surface, and the bottom surface of the head 131 are covered by the corrosion-resistant plating film 138. Therefore, it is possible to provide a highly corrosion-resistant head which can be used in the formation of ceramic-containing films requiring high temperatures. In addition, since the expansion coefficient of the plating film 138 is relatively close to those of the base materials included in the first plate 132, the second plate 134, and the third plate 136, peeling of the plating film 138 can be prevented even in film formation at a high temperature. Furthermore, diffusion bonding is used for bonding the first plate 132 and the second plate 134 and the bonding of the second plate 134 and the third plate 136, while brazing is not applied. Hence, the channel is not blocked by the brazing material or its residues, and it is possible to provide a head with a controlled structure capable of uniformly ejecting a reactive gas.

There is also no restriction on the number of plates in the head 131, and the number of plates may be two, four, or more. Regardless of the number of plates, adjacent plates are bonding to each other via the bonding layer in contact with these plates, and the bonding layer consists of the plating films 138 formed on the adjacent plates.

### <Third Embodiment>

In this embodiment, the stage 160 according to an embodiment of the present invention is explained. An explanation of the structures the same as or similar to those described in the First or Second embodiment may be omitted.

### 1. Structure of Stage

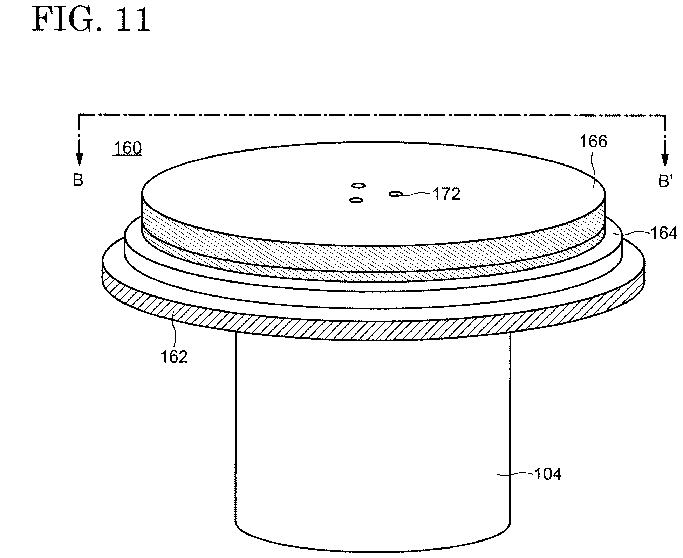

A schematic perspective view of the stage 160 is shown in FIG. 11. As shown in FIG. 11, the stage 160 is provided over a shaft 104 and includes, as its fundamental components, a first supporting plate 162 supported by the shaft 104, a second supporting plate 164 over the first supporting plate 162, and a third supporting plate 166 over the second supporting plate 164. A substrate is placed over the third supporting plate 166. Although not illustrated, the stage 160 may further be provided with an electrostatic chuck over the third supporting plate 166 to fix the substrate. Although the first supporting plate 162, the second supporting plate 164, and the third supporting plate 166 each have a disk shape in FIG. 11, there are no restrictions on the shape of these plates, and these supporting plates may be shaped to fit the shape of the substrate to be used. For example, the planar shape of the first supporting plate 162, the second supporting plate 164, and the third supporting plate 166 may be polygonal, including square and rectangular. Although the stage 160 is configured so that the planar shapes of the first supporting plate 162, the second supporting plate 164, and the third supporting plate 166 decrease in this order, the sizes of the planar shapes of these plates may be identical. In addition, when the sizes of the planar shapes are different, there is no restriction on their order.

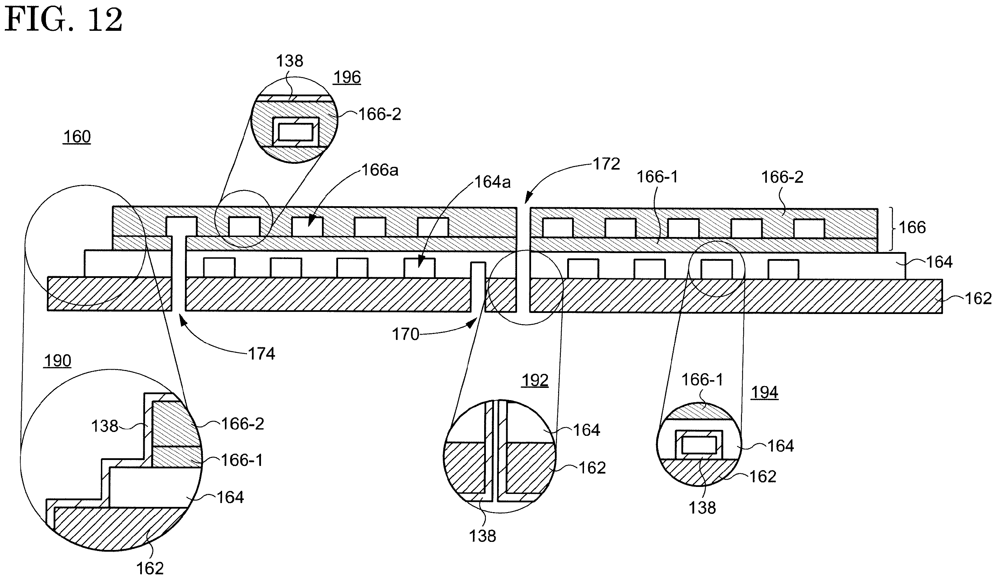

A schematic cross-sectional view of the stage 160 is shown in FIG. 12. The third supporting plate 166 may include, for example, a lower plate 166-1 and an upper plate 166-2 bonded to the lower plate 166-1, and one or a plurality of trenches 166a is formed in at least one of the lower plate 166-1 and the upper plate 166-2. A heater for heating which is not illustrated is placed in each trench 166a. A sheath heater, in which an electric heating wire is covered with an inorganic insulating material and the inorganic insulating material is further covered with a metal film, may be used as the heater. The outer diameter of the heater is, for example, equal to or larger than 3.0 mm and equal to or smaller than 11.0 mm, and thus the trench 166a may also be formed to have a width and a height which allow the heater having the aforementioned outer diameter to be accommodated. The heater is connected to a heater power supply 116 (see FIG. 1) and is controlled by the current supplied from the heater power supply 116. Note that a through hole 174 reaching the trench 166a from a bottom surface of the first supporting plate 162 is provided in the first supporting plate 162 and the second supporting plate 164 to connect the heater to the heater power supply 116. Although not illustrated, the third supporting plate 166 may be structured with a single plate having the trench 166a capable of accommodating the heater. In this case, the heater may be placed between the third supporting plate 166 and the second supporting plate 164 and may be in contact with the second supporting plate 164.

The second supporting plate 164 is sandwiched between the third supporting plate 166 and the first supporting plate 162 and bonded thereto. A channel 164a for circulating a cooling medium is formed in at least one of the first supporting plate 162 and the second supporting plate 164. The height and the width of the channel 164a may be selected from a range equal to or larger than 2 mm and equal to or smaller than 3 cm, for example. The channel 164a is connected to the temperature controller 120 through the shaft 104, and a temperature-controlled cooling medium is introduced into the channel 164a. Note that a through hole (not illustrated) is provided in the first supporting plate 162 to connect the channel 164a to the temperature controller 120.

The stage 160 is further provided with a bottomed hole 170 for inserting a thermocouple to measure a temperature of the stage 160 as well as one or a plurality of through holes 172 for supplying a gas with high thermal conductivity such as helium to the surface of the third supporting plate 166. The bottom hole 170 may reach the third supporting plate 166 passing through the second supporting plate 164 or may not pass through the second supporting plate 164. The through hole 172 passes through the first supporting plate 162, the second supporting plate 164, and the third supporting plate 166 and is connected to a gas-supplying source which is not illustrated. The thermal energy of the heater can be efficiently transferred to the substrate by supplying a gas having high thermal conductivity to the gap between the third supporting plate 166 and the substrate through the through-hole 172.

Similar to the head 130, the first supporting plate 162 and the second supporting plate 164 of the stage 160 are bonded to each other by diffusion bonding as described below. Similarly, the second supporting plate 164 and the third supporting plate 166 are also bonded to each other by diffusion bonding. Thus, the first supporting plate 162 and the second supporting plate 164 are in direct contact with each other, and the second supporting plate 164 and the third supporting plate 166 are also in direct contact with each other. Moreover, at the interface between the first supporting plate 162 and the second supporting plate 164 and the interface between the second supporting plate 164 and the third supporting plate 166, there is no brazing material frequently used in metal-to-metal bonding or its residue, and there is no component derived from the brazing material, or the concentration thereof is extremely lower than the concentration of these components in the bulk of the first supporting plate 162, the second supporting plate 164, and the third supporting plate 166. Furthermore, no brazing material nor residue thereof is present on the sidewalls of the through holes 172 forming the channels for the high thermal-conductivity gas, or the like.

As described below, the plating film 138 can be formed by electroless plating after bonding the first supporting plate 162, the second supporting plate 164, and the third supporting plate 166. Hence, the stage 160 is further provided with the plating film 138 as shown in the enlarged schematic views of the regions 190, 192, 194, and 196 in FIG. 12. The plating film 138 covers the bottom surface and the side surface of the first supporting plate 162, the side surface of the second supporting plate 164, and the side surface and the top surface of the third supporting plate 166. In addition, the plating film 138 may also cover the top surface or the bottom surface of each supporting plate exposed from the adjacent supporting plate. As shown in the regions 190, 192 and the like, the plating film 138 is continuous over the adjacent supporting plates. In addition, the plating film 138 may cover the surface exposed to the trench 166a of the third supporting plate 166, the surfaces of the first supporting plate 162 and the second supporting plate 164 exposed to the channel 164a, the side wall of the through hole 174, the bottom surface and the side wall of the bottomed hole 170, and the side walls of the through holes 172. Note that the plating film 138 may not cover the surfaces which are not in contact with the reactive gas, specifically, the surface of the third supporting plate 166 exposed to the trench 166a, the surfaces of the first supporting plate 162 and the second supporting plate 164 exposed to the channel 164a, the side wall of the through hole 174, and the bottom surface or the side wall of the bottomed hole 170.

Coating the surfaces of the stage 160 which may come in contact with the reactive gases (*i.e.*, the bottom surface and the side surface of the first supporting plate 162, the side surface of the second supporting plate 164, the side surface and the top surface of the third supporting plate 166, the top surface or the bottom surface of each plate exposed from the adjacent plate, and the side walls of the through holes 172) with the plating film 138 protects the first plate 132, the second plate 134, and the third plate 136 from corrosion-resistant reactive gases. Therefore, corrosion of the stage 160 by reactive gases during film formation can be effectively prevented. Hence, it is possible to provide a highly corrosion-resistant stage which can be used not only in formation and processing of metal films but also in formation and processing of ceramic-containing films requiring high temperatures. In addition, since the expansion coefficient of the plating film 138 is relatively close to those of the base materials included in the first supporting plate 162, the second supporting plate 164, and the third supporting plate 166, peeling of the plating film 138 can be prevented even in film formation at a high temperature.

### 2. Manufacturing Method of Stage

The first supporting plate 162, the second supporting plate 164, and the lower plate 166-1 and the upper plate 166-2 of the third supporting plate 166 are fabricated by cutting corresponding metal or alloy plates as appropriate. The structures of the trench 166a and the channel 164a provided in the stage 160 may be appropriately determined according to the size of the stage 160 and the heater capacity.

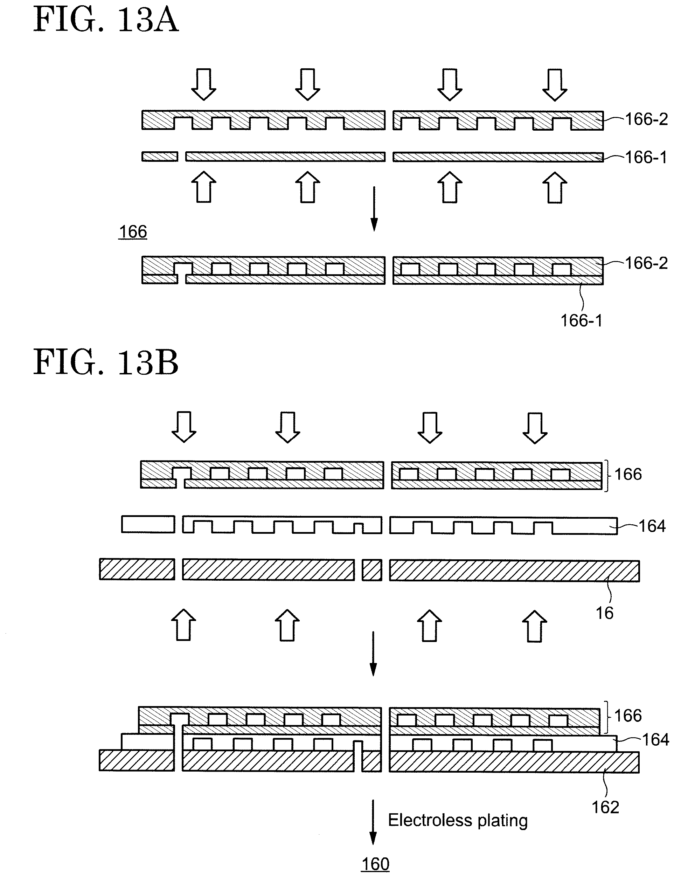

Next, the lower plate 166-1 and the upper plate 166-2 are bonded with the heater, which is not illustrated, arranged in the trench 166a to fabricate the third supporting plate 166 (FIG. 13A). The bonding at this time may be performed by diffusion bonding or brazing. This is because the influence of the residual brazing material is negligible due to the large size of the trench 166a compared with the through holes 136a formed in the third plate 136 of the head 130 and because the brazing material remaining in the through hole 172 can be relatively readily removed mechanically before bonding the second supporting plate 164 and the first supporting plate 162. When binding the lower plate 166-1 and the upper plate 166-2 by brazing, the brazing material or the residue thereof is present therebetween.

Next, similar to the head 130, the first supporting plate 162, the second supporting plate 164, and the third supporting plate 166 are bonded (FIG. 13B). The first supporting plate 162, the second supporting plate 164, and the third supporting plate 166 may be simultaneously bonded with the second supporting plate 164 sandwiched between the first supporting plate 162 and the third supporting plate 166, or two supporting plates may be first bonded and then the remaining supporting plate may be bonded. Diffusion bonding is used in this bonding process.

After bonding is completed, electroless plating is performed, leading to the production of the stage 160 shown in FIG. 12 and the like. After the electroless plating is completed, the head 130 is cleaned with a cleaning solution such as water. When the plating film 138 is not formed on all or a part of the surface of the third supporting plate 166 exposed to the trench 166a, the surfaces of the first supporting plate 162 and the second supporting plate 164 exposed to the channel 164a, the side wall of the through hole 174, and the bottom surface and the side wall of the bottomed hole 170, these surfaces may be masked before the electroless plating.

In the manufacturing method of the head 130 according to an embodiment of the present invention, diffusion bonding is used in bonding the first supporting plate 162, the second supporting plate 164, and the third supporting plate 166, and no bonding by brazing is performed. Therefore, the brazing material used in brazing and the residue thereof do not exist not only on the outer surface but also in the channel 164a, the through holes 172, and the like. Similar to the through hole 136a of the head 130, the diameter variation of the plurality of through holes 172 are preferred to be small to uniformly eject the high thermal-conductivity gas. Furthermore, the through holes 172 are also designed to have a relatively small diameter (*e.g.*, equal to or larger than 0.3 mm and equal to or smaller than 5 mm). Therefore, when the first supporting plate 162, the second supporting plate 164, and the third supporting plate 166 are bonded by brazing, the brazing material or the residue thereof may flow into the through holes 172, which may block the through holes 172 or cause variation in the flow rate of the high thermal-conductivity gas flowing through the plurality of through holes 172. This may result in variation in the temperature of the surface of the stage 160, leading to the non-uniformity of composition, thickness, density, and the like of the film to be formed over the substrate. However, since the first supporting plate 162, the second supporting plate 164, and the third supporting plate 166 are bonded using diffusion bonding in the manufacturing method of the stage 160 according to an embodiment of the present invention, the influences of the residual brazing material or the residue thereof are completely eliminated and the high thermal-conductivity gas can be uniformly supplied to the upper surface of the stage 160 without affecting the channel of the high thermal-conductivity gas.

### 3. Modified Example

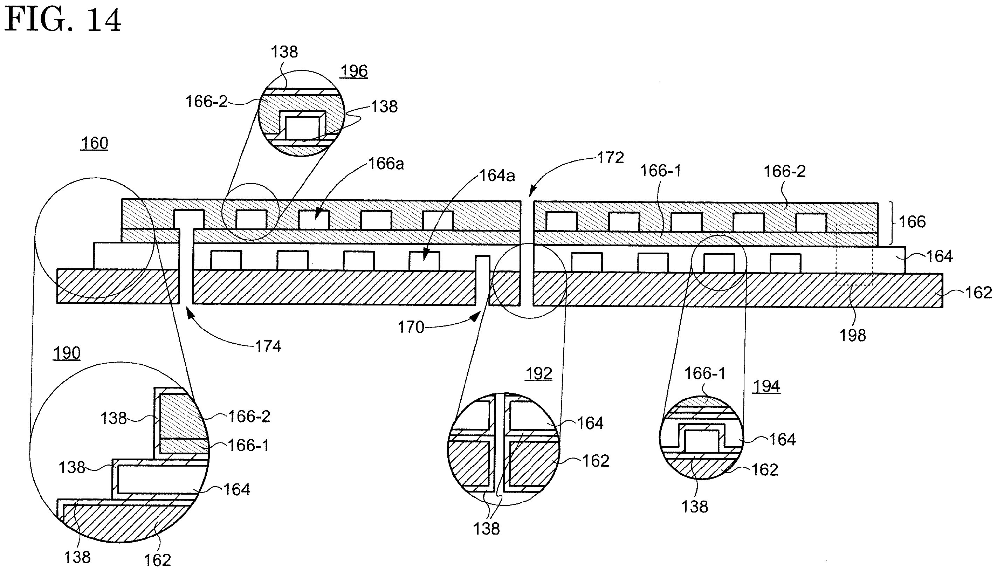

Similar to the head 131 described in the Second Embodiment, the stage 160 may be manufactured by applying electroless plating to each of the first supporting plate 162, the second supporting plate 164, and the third supporting plate 166, followed by bonding these plates. Thus, as shown in FIG. 14, the stage 160 according to this modified example may have the plating film 138 between the first supporting plate 162 and the second supporting plate 164 and between the second supporting plate 164 and the third supporting plate 166. Specifically, as shown in the enlarged schematic views of the regions 190, 192, 194, and 196 in FIG. 14, not only is the plating film 138 provided on the side surface and the bottom surface of the first supporting plate 162, the side surface of the second supporting plate 164, the top surface and the side surface of the third supporting plate 166, the surfaces of each plate exposed from adjacent plates, and the side walls of the through holes 172, but also the first supporting plate 162 and the second supporting plate 164 are bonded through the plating film 138, and the second supporting plate 164 and the third supporting plate 166 are bonded through the plating film 138. In other words, the first supporting plate 162 and the second supporting plate 164 are bonded through a bonding layer in direct contact with the first supporting plate 162 and the second supporting plate 164, and this bonding layer consists of the plating films 138 formed on the first supporting plate 162 and the second supporting plate 164. Similarly, the second supporting plate 164 and the third supporting plate 166 are bonded through a bonding layer in direct contact with the second supporting plate 164 and the third supporting plate 166, and this bonding layer consists of the plating films 138 formed on the second supporting plate 164 and the third supporting plate 166.

As can be understood from the schematic cross-sectional view demonstrated in FIG. 14, similar to the head 131 described in the Second Embodiment, the stage 160 according to this modified example is manufactured by applying electroless plating to each of the first supporting plate 162, the second supporting plate 164, and the third supporting plate 166 to form the plating film 138 on the surface thereof, followed by diffusion-bonding the first supporting plate 162, the second supporting plate 164, and the third supporting plate 166. Therefore, the base materials included in the first supporting plate 162, the second supporting plate 164, and the third supporting plate 166 are preferred to have a higher melting point than the plating film 138. Specifically, the base materials are preferred to be Invar, Inconel, or stainless steel. Although not illustrated, there may be two layers of the plating film 138 between adjacent supporting plates, and the two layers of the plating film 138 may be integrated by diffusion bonding to form one layer of the plating film 138, similar to the head 130 (see FIG. 9A and FIG. 9B).

In the stage 160 according to this modified example, not only the side walls of the through holes 172 but also the top surface, the side surface, and the bottom surface are coated with the highly corrosion-resistant plating film 138. Therefore, it is possible to provide a highly corrosion-resistant head which can be used in the formation of ceramic-containing films where high temperatures are required. In addition, since the expansion coefficient of the plating film 138 is relatively close to those of the base materials included in the first supporting plate 162, the second supporting plate 164, and the third supporting plate 166, peeling of the plating film 138 can also be prevented even in film formation at high temperatures. Furthermore, diffusion bonding is used but the brazing is not performed for the bonding of the first supporting plate 162 and the second supporting plate 164 and for the bonding of the second supporting plate 164 and the third supporting plate 166. Therefore, the through holes 172 are not blocked by the brazing material or the residue thereof, and the high thermal-conductivity gas can be uniformly supplied to the substrate side.

The aforementioned modes described as the embodiments of the present invention can be implemented by appropriately combining with each other as long as no contradiction is caused. Furthermore, any mode which is realized by persons ordinarily skilled in the art through the appropriate addition, deletion, or design change of elements or through the addition, deletion, or condition change of a process is included in the scope of the present invention as long as they possess the concept of the present invention.

It is understood that another effect different from that provided by each of the aforementioned embodiments is achieved by the present invention if the effect is obvious from the description in the specification or readily conceived by persons ordinarily skilled in the art.

### REFERENCES SIGNS LIST

100: CVD apparatus, 102: Chamber, 104: Shaft, 108: Exhaust device, 110: Microwave source, 112: Magnet, 114: Power supply, 116: Heater power supply, 118: Power supply, 120: Temperature controller, 130: Head, 130a: Opening, 131: Head, 132: First plate, 132a: Through hole, 132b: Through hole, 133: Channel, 134: Second plate, 134a: Through hole, 134b: Recessed portion, 136: Third plate, 136a: Through hole, 136b: Recessed portion, 136c: Partition, 137: Fourth plate, 137a: Through hole, 138: Plating film, 140: Region, 142: Region, 144: Region, 146: Region, 150: Region, 152: Region, 154: Region, 156: Region, 158: Region, 160: Stage, 162: First supporting plate, 164: Second supporting plate, 164a: Channel, 166: Third supporting plate, 166-1: Lower plate, 166-2: Upper plate, 166a: Trench, 170: Bottomed hole, 172: Through hole, 174: Through hole, 190: Region, 192: Region, 194: Region, 196: Region

## Claims

1. A method for manufacturing a head for ejecting a reactive gas for film formation, the method comprising:
diffusion-bonding a first plate and a second plate to each other; and
forming, after the diffusion bonding, a nickel-containing film on surfaces of the first plate and the second plate with electroless plating,
wherein the first plate and the second plate are configured to have a channel through which the reactive gas passes from a side of the first plate to a side of the second plate in a state where the first plate and the second plate are bonded.

2. A method for manufacturing a head for ejecting a reactive gas for film formation, the method comprising:
forming a nickel-containing film on surfaces of a first plate and a second plate with electroless plating; and
diffusion-bonding the first plate and the second plate to each other after the formation of the nickel-containing film,
wherein the first plate and the second plate are configured to have a channel through which the reactive gas passes from a side of the first plate to a side of the second plate in a state where the first plate and the second plate are bonded.

3. The method according to claim 1, further comprising diffusion-bonding a third plate to the second plate before forming the nickel-containing film,
wherein the first plate, the second plate, and the third plate are configured to have a channel through which the reactive gas passes from a side of the first plate to a side of the third plate in a state where the first plate, the second plate, and the third plate are bonded.

4. The method according to claim 3, further comprising diffusion-bonding a fourth plate to the third plate before forming the nickel-containing film,
wherein the first plate, the second plate, the third plate, and the fourth plate are configured to have a channel through which the reactive gas passes from a side of the first plate to a side of the fourth plate in a state where the first plate, the second plate, the third plate, and the fourth plate are bonded.

5. The method according to claim 2, further comprising:
forming a nickel-containing film on a surface of a third plate with electroless plating; and
diffusion-bonding the third plate on which the nickel-containing film is formed to the second plate,
wherein the first plate, the second plate, and the third plate are configured to have a channel through which the reactive gas passes from a side of the first plate to a side of the third plate in a state where the first plate, the second plate, and the third plate are bonded.

6. The method according to claim 5, further comprising:
forming a nickel-containing film on a surface of a fourth plate with electroless plating; and
diffusion-bonding the fourth plate on which the nickel-containing film is formed to the third plate,
wherein the first plate, the second plate, the third plate, and the fourth plate are configured to have a channel through which the reactive gas passes from a side of the first plate to a side of the fourth plate in a state where the first plate, the second plate, the third plate, and the fourth plate are bonded.

7. The method according to claim 1 or 2,
wherein the first plate and the second plate include an alloy containing aluminum as a major component or an alloy containing iron and nickel.

8. The method according to claim 3 or 5,
wherein the first plate, the second plate, and the third plate include an alloy containing aluminum as a major component or an alloy containing iron and nickel.

9. The method according to claim 4 or 6,
wherein the first plate, the second plate, the third plate, and the fourth plate include an alloy containing aluminum as a major component or an alloy containing iron and nickel.

10. A head for ejecting a reactive gas for film formation, the head comprising:
a first plate;
a second plate diffusion-bonded to the first plate; and
a nickel-containing film covering surfaces of the first plate and the second plate,
wherein the first plate and the second plate are configured to have a channel through which the reactive gas passes from a side of the first plate to a side of the second plate.

11. A head for ejecting a reactive gas for film formation, the head comprising a first plate and a second plate each coated with a nickel-containing film,
wherein the first plate and the second plate are bonded to each other through a first bonding layer in contact with the first plate and the second plate,
the first bonding layer consists of the nickel-containing films of the first plate and the second plate, and
the first plate and the second plate are configured to have a channel through which the reactive gas passes from a side of the first plate to a side of the second plate.

12. The head according to claim 10, further comprising a third plate diffusion-bonded to the second plate,
wherein the nickel-containing film further covers a surface of the third plate.

13. The head according to claim 12, further comprising a fourth plate diffusion-bonded to the third plate,
wherein the nickel-containing film further covers a surface of the fourth plate.

14. The head according to claim 13, further comprising a third plate covered by a nickel-containing film,
wherein the second plate and the third plate are bonded to each other through a second bonding layer in contact with the second plate and the third plate,
the second bonding layer consists of the nickel-containing films of the second plate and the third plate, and
the first plate, the second plate, and the third plate are configured to have a channel through which the reactive gas passes from a side of the first plate to a side of the third plate.

15. The head according to claim 14, further comprising a fourth plate covered by a nickel-containing film,
wherein the third plate and the fourth plate are bonded to each other through a third bonding layer in contact with the third plate and the fourth plate,
the third bonding layer consists of the nickel-containing films of the third plate and the fourth plate, and
the first plate, the second plate, the third plate, and the fourth plate are configured to have a channel through which the reactive gas passes from a side of the first plate to a side of the fourth plate.

16. The head according to claim 10 or 11,
wherein the first plate and the second plate include an alloy containing aluminum as a major component or an alloy containing iron and nickel.

17. The head according to claim 12 or 14,
wherein the first plate, the second plate, and the third plate include an alloy containing aluminum as a major component or an alloy containing iron and nickel.

18. The head according to claim 13 or 15,
wherein the first plate, the second plate, the third plate, and the fourth plate include an alloy containing aluminum as a major component or an alloy containing iron and nickel.
